# EUROPEAN PATENT APPLICATION

(11) **EP 1 601 096 A1**
(43) Date of publication of application: **30.11.2005**
(21) Application number: 04360054.3
(22) Date of filing: 27.05.2004
(51) Int. Cl.: H03F 1/02, H03F 1/34

(54) **Bias voltage adjusting method and electronic loop circuit**

(71) Applicant: ALCATEL, 75008 Paris (FR)
(72) Inventor: Schlesinger, Heinz, 73395 Mundelsheim (DE)
(74) Representative: Kohler Schmid Möbus

(57) **Abstract**

This invention relates to a bias voltage adjusting method of a power amplifier stage transistor of a base station and an electronic loop circuit, being designed to perform the steps of the bias voltage adjusting method. Such methods and circuits are used for efficiency improvement of power amplifier chains preferably within UMTS base stations, in general sending stages of broad band mobile communication systems. The inventive electronic loop circuit is comprising:
- decoupling means 10, being designed to decouple a fraction of a radio signal to be transmitted,
- an analogue/digital converter 14, being designed to convert said fraction of the radio signal to a digitalized signal,
- ACLR analysing means 16, being designed to perform an ACLR analysis of said digitalized signal by calculating an ACLR value from the digitalized signal,
- an ACLR optimiser 18, being designed to calculate a bias voltage value within ACLR requirements,
- a digital/analogue converter 20, being designed to convert said value to an analogue voltage and
- voltage applying means 22, being designed to apply said voltage to said transistor 5 as a bias voltage.

## Description

This invention relates to a bias voltage adjusting method of a power amplifier stage transistor of a base station and an electronic loop circuit, being designed to perform the steps of the bias voltage adjusting method. Such methods and circuits are used for efficiency improvement of power amplifier chains preferably within UMTS base stations, in general sending stages of broad band mobile communication systems.

Efficiency improvement of power amplifiers is one of the major problems in the analogue transmitter chain of communication systems using bandwidth efficient modulation schemes and multi-carrier operation. When a power amplifier is required to work under a wide frequency range, the electrical characteristics of the transistor of the power amplifier move away from optimum values. High frequency (power end stage) transistors can only be operated optimally in a small frequency range of about 100 MHz. Therefore, multi-band basestations of communication systems are proposed, working in a frequency range, of more than one GHz. If power transistors are operated in a small frequency range the electrical parameters of the transistors do not change a lot, depending on the operating frequency. Therefore bias voltages, i.e. the adjustment of the resting current of these transistors can be chosen as to be constant. If the transistor has to be operated in a bigger frequency range, as is requested in wide band applications, the electrical parameters of the transistor are varying significantly in dependence of the operating frequency.

Amplifiers are electronic components which generally exhibit nonlinear behaviour, meaning that the output signal is often distorted compared to the input signal. Digital communication systems with non constant envelope modulation are limited by the non-linearities of the power amplifier. This leads to a very poor efficiency of the amplification device. For this reason telecommunication systems include means for linearizing the amplifiers. Methods for the efficiency optimization e.g. digital predistortion are developed.
The method most widely used consists of applying predistortion to the signals upstream of the amplifier input, the predistortion being such that a signal is obtained at the output of the amplifier which faithfully represents the input signal before predistortion is applied. The predistortion can be digital or analogue.

Other existing systems are using a peak to average reduction of the signal (clipping) together with a digital predistortion of the W-CDMA signals to increase the power amplifier efficiency. The biasing of the power amplifier is often fixed in these solutions. Increasing the efficiency of an amplifier by applying a clipping method which consists of limiting the amplitude of the signal at the input of the amplifier to a maximum value is well known in the art. The limit or threshold value (clipping radius) is determined as a function of the most unfavourable case of signals to be transmitted by the transmission system of which the amplifier is part, i.e. as a function of the greatest possible ratio between the peak power and the average power of that signal.

Any distortion or attenuation defect of the signal must conform to the quality and fidelity constraints of the transmission system, which are defined by specific standards. In case of UMTS signals, these constraints are defined by 3GPP standards. 3GPP and 3GPP2 are new world wide standards for the creation, delivery and playback of multimedia via 3rd generation, high-speed wireless networks, for example Wideband Code Division Multiple Access (W-CDMA) systems. Defined by the 3rd Generation Partnership Project and 3rd Generation Partnership Project 2 respectively, these standards seek to provide uniform delivery of multimedia over newly evolved broadband mobile networks (3rd generation networks) to the latest multimedia-enabled wireless devices. According to these standards an Adjacent Channel Leakage Power Ratio (ACLR) is defined as the ratio of a transmitted power to a power measured after a receiver filter in the adjacent channel. According to said standards this ACLR must not exceed specific values to meet the requirements of the standards.

The minimum ACLR (Adjacent Channel Leakage Ratio) requirements for a Base Station (BS) are defined in the 3 GPP specification TS 25.104 section 6.6.2.2.1.
The maximum tolerable ACLR shall be higher than the values specified in the following table:

| | |
|---|---|
| BS adjacent channel offset below the first or above the last carrier frequency used | ACLR limit |
| 5 MHz | 45 dB |
| 10 MHz | 50 dB |

In many power amplifier applications the ACLR values are optimised to values much below these requirements. A typical ACLR spectrum of oversized ACLR values of a power amplifier output stage has the following ACLR values:

| ACLR at-5 MHz | ACLR at+5 MHz | ACLR at-10 MHz | ACLR at+10 MHz | Margin to 3GPP Standard |
|---|---|---|---|---|
| - 55 dB | - 54 dB | - 62 dB | - 61 dB | 10 dB at ± 5 MHz |
| | | | | 12dBat±10MHz |

There is an unnecessary huge margin to the requirements according the 3GPP standard.

The power amplifier, e.g. of an UMTS base station, is used in class-A operation for best linearity amplification. Both techniques, clipping and predistortion, usually use a fixed power amplifier biasing. Therefore, the power amplifier current is very high. This causes a poor efficiency. To optimise the efficiency the operation point (biasing) of the power amplifier has to be adapted.

In the United States patent application publications US 2003/0091123A1 or US 2003/0092462A1 methods for optimising the efficiency of power amplifiers are described, wherein the operating point of a power amplifier is adopted according to power estimates provided by power estimation devices. The power estimates depend on the input signal of different transmitting channels of the amplifier. Furthermore, the rate of change of the operating point of the amplifier is conditioned according to a state of convergence of predistortion parameters, selected according to an output power value of the amplifier, which is measured by an output power measuring unit. Predistortion parameters and operating point parameters are conditioned in a control loop.

A disadvantage of this method is the fact that the convergence time of the control loop depends on the quality of the power estimation. This fact might affect the usability of the methods, because the control loop might be unstable if the estimation fails to be sufficiently correct. Furthermore, the method is complicated because of the power estimation. Therefore, an electronic circuit implementing the method is expensive to produce.

It is therefore an object of the invention to provide a bias voltage adjusting method of a power amplifier stage transistor of a base station and an electronic loop circuit for adjusting the bias voltage of a power amplifier which overcome the problems associated with the related art, in particular which enable a fast and secure adoption of the bias voltage of the amplifier.

The object concerning the bias voltage adjusting method is attained by the method defined in claim 1 and the object concerning the electronic loop circuit is attained by the circuit according to claim 5.

Further advantageous features of the invention are defined in the depending claims.

The inventive bias voltage adjusting method of a power amplifier of a base station is comprising the step of decoupling a fraction of a radio signal to be transmitted. According to the invention said fraction of the radio signal is converted to a digitalised signal and an ACLR analysis of said digitalised signal is performed by calculating an ACLR value from the digitalised signal. After that a bias voltage value within ACLR requirements is calculated, meaning the ACLR values of the amplified signal at this bias voltage value are required to be within ACLR requirements, and converted to an analogue voltage and said voltage is applied to said transistor as a bias voltage.
The step of calculating a bias voltage value within ACLR requirements is performed, for example by looking up the bias voltage from a table comprising given bias voltage values depending on ACLR values at different operating frequencies. The inventive method may be applied several times again, preferably in a control loop, if necessary to adopt the bias voltage to get to an amplified signal within ACLR requirements. Therefore some different bias voltage values are applied to the transistor. For each bias voltage value an ACLR Analysis is performed and the bias voltage value leading to the best ACLR value is chosen.

The Adjacent Channel Leakage power Ratio (ACLR) is the ratio of the Root Raised Cosine (RRC) filtered mean power centred on the assigned channel frequency to the RRC filtered mean power centred on an adjacent channel frequency. The basic idea of the invention is the transition from fixed bias voltages to reconfigure bias voltages as a function of the operating frequency. According to the invention the ACLR margin is reduced nearly to the allowed required values within the 3GPP Standard by adjusting the bias voltage (U_{bias}) of the power transistor depending on the operating frequency. Therefore the supply current (I_{D}) of the power transistor is reduced considerably.

The inventive method results at least in the following advantages:
- Broadband operating of different operating bands, e.g. DCS or UMTS, using one high frequency front end is made possible at an optimal efficiency of the front end.
- An optimal adjustment of the transistor bias voltage in W-CDMA systems is made possible.
- The supply current (I_{D}) of the transistor is reduced considerably, thus the power consumption is decreased.
- Increased power amplifier, e.g. high frequency end stage, efficiency.
- Optimised thermal conditions within the whole device, comprising a power amplifier being operated according to the inventive method, because of lower I_{D} which results in an improvement of the thermal characteristics of the transistor (less cooling is necessary).
- An adaptive bias control of the power amplifier is performed whereby the amplifier current (I_{D}) is reduced.
- The output power of the base station transmit circuit is increased.
- Higher integration of the transmit module due to an optimised power amplifier chain is made possible, resulting in a smaller construction size of the base station.
- Only very little additional hardware for adapting the bias voltage, i.e. a Digital/Analogue converter, and for downconverting the decoupled signal, i.e. a downconverter mixer, is required for the adaptive bias control. The ACLR analysis can be performed using an existing microprocessor or controller.

Therefore, an optimal adjustment of the operating electrical current of a final stage transistor is made possible, simultaneously allowing a suppression of neighbouring (adjacent) frequencies in W-CDMA Systems according to ACLR is made possible due to controlling of the bias voltage of broad band frequency applications.

Preferably, the step of downconverting said fraction of said radio signal to a baseband of low or medium Intermediate Frequency (IF) is performed before converting said fraction of the radio signal to said digitalised signal. Therefore, the calculating of the ACLR value can be performed by analysing the downconverted adjacent channels in digital domain, even at high operating frequencies. The calculating of the ACLR value is preferably carried out by digital bandwidth filtering and digital stepping of the centered frequencies with e.g. 30 KHz and finally digitally RRC- weighting of the individual amplitude or power responses. These steps of the inventive method are comparable to the basic principle of a spectrum analyser.

Preferably, said ACLR analysis is comprising a Fast Fourier Transformation (FFT). As a result of the FFT power values depending on frequencies are obtained. To calculate the ACLR, i.e. to perform the ACLR analysis, power values of frequencies between a frequency gap are summed up and divided by a sum of power values of frequencies beyond said frequency gap. A FFT enables a fast ACLR analysis using proved technology.

In another preferred embodiment of the invention, a drain current value of a drain current of said transistor is measured. Preferably, said drain current value is converted into a digitalised current value. After that, said bias voltage value is calculated from said preferably digitalised current value. If the current value turns out to be too high, it has to be decreased, i.e. the bias voltage value has to be set to a lower value if possible without leaving the range of the ACLR requirements of 3GGP standards. Therefore, the operating current of the transistor is controlled directly, which leads to a supplementary decreasing of the operating current of the transistor.

An inventive electronic control loop circuit for adjusting the bias voltage of a power amplifier stage transistor which stimulates an antenna, is comprising:
- decoupling means, being designed to decouple a fraction of a radio signal to be transmitted,
- an analogue/digital converter, being designed to convert said fraction of the radio signal to a digitalised signal,
- ACLR analysing means, being designed to perform an ACLR analysis of said digitalised signal by calculating an ACLR value from the digitalised signal,
- an ACLR optimiser, being designed to calculate a bias voltage value within ACLR requirements,
- a digital/analogue converter, being designed to convert said value to an analogue voltage and
- voltage applying means, being designed to apply said voltage to said transistor as a bias voltage.

The inventive electronic loop circuit is designed to perform the steps of the inventive method. Therefore, it makes available the advantages being provided by the inventive method.

Advantageously, the electronic loop circuit is comprising an analogue downconverter mixer, being designed to downconvert said fraction of said radio signal to a baseband of low or medium Intermediate Frequency (IF). Therefore, said converting of said fraction of the radio signal into a digitalised signal can be carried out even at very high operating frequencies without much effort.

In another preferred embodiment of the invention, said electronic loop circuit is comprising:
- drain current measuring means, being designed to measure a drain current value of a drain current of said transistor,
- a second analogue/digital converter, being designed to convert said drain current value into a digitalised current value,
wherein said ACLR optimiser is being designed to calculate said bias voltage value from said digitalised current value. The calculating is executed in a way that the amplified signal meets the ACLR requirements of the 3GPP standards, for example by looking up the bias voltage to be applied to the transistor from a table, comprising bias voltage values depending on operating frequencies, ACLR values and operating current (drain current) values.
Therefore, the operating current of the transistor can be controlled directly.

Advantageously, said electronic loop circuit, preferably said ACLR analysing means and/or said ACLR optimiser, is comprising at least one micro processor, preferably a Field Programmable Gate Array (FPGA) or a Digital Signal Processor (DSP). Said microprocessor is loaded with a computer program with software code sections by which the steps of
- converting said fraction of the radio signal to a digitalised signal,
- performing an ACLR analysis of said digitalised signal by calculating an ACLR value from the digitalised signal,
- calculating a bias voltage value within ACLR requirements,
- converting said value to an analogue voltage
are carried out. To implement those steps of the inventive method as a computer program and to load said computer program in a FPGA or a Digital Signal Processor DSP being part of the bias control stage is the most appropriate, especially cheapest and fastest way to implement the inventive method.

The inventive power amplifier circuit is preferably implemented as a part of a transmitter circuit, which preferably is a part of a base station of a telecommunication system.

The different features of the preferred embodiments of the invention may be used in combination together with the invention as set forth in the independent claims or just each single preferred embodiment together with the invention as set forth in the independent claims.

The embodiments of the invention will now be described with reference to the accompanying drawings.
Figure 1 shows a power amplifier basic block diagram according to the state of the art.
Figure 2 shows a block diagram of an inventive electronic loop circuit for adjusting the bias voltage of a power amplifier stage transistor.

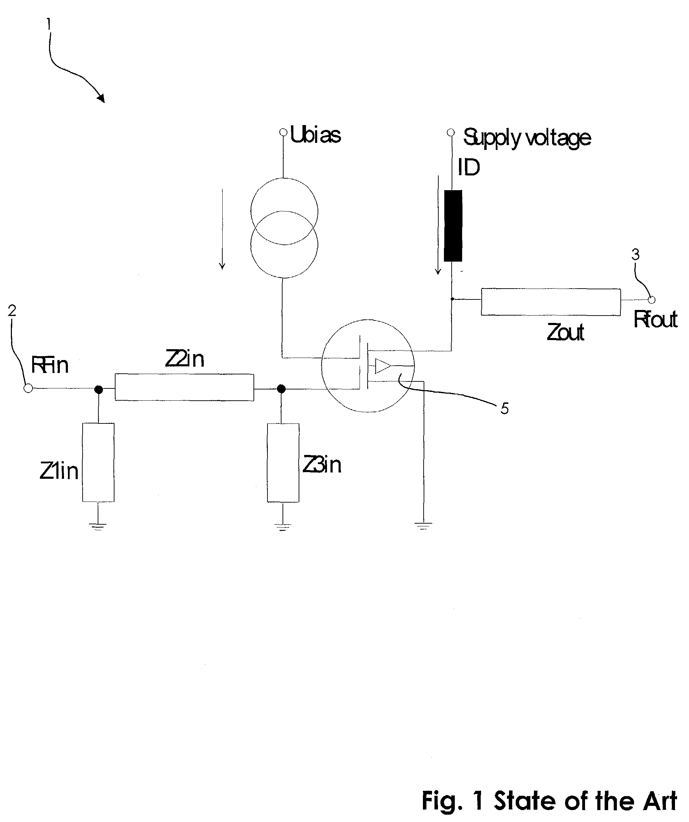

In figure 1 the basic block diagram of a power amplifier stage 1 according to the state of the art is outlined. High frequency input is at RFᵢₙ 2. The amplified output power RFₒᵤₜ 3 can drive an antenna or a further transistor stage. The Bias voltage (U_{bias}) defines the point of operation in view of Drain current (I_{D}), gain and output spectrum characteristics of the transistor 5 (power transistor).

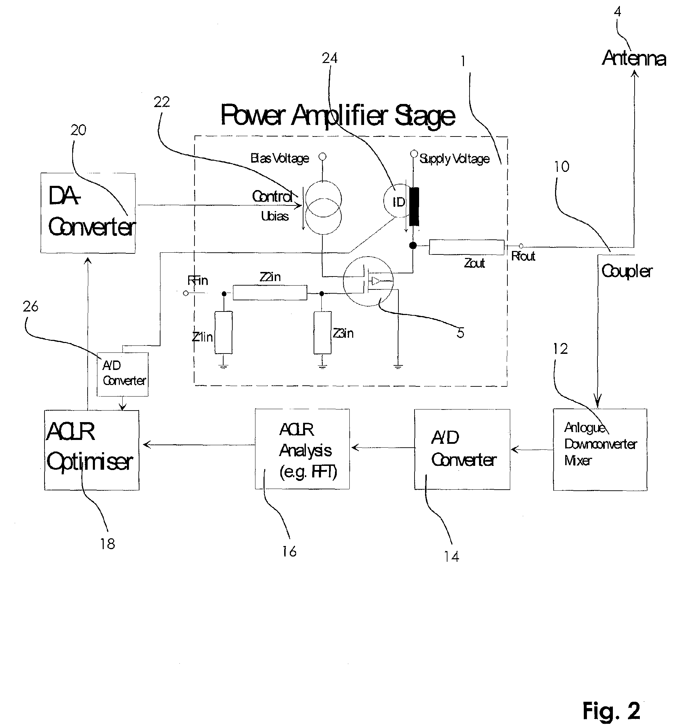

In figure 2 the transmit chain of a UMTS base station is shown schematically as an implementation example of an inventive electronic loop circuit having a variable bias voltage with respect to sufficient ACLR values. The inventive electronic loop circuit is being designed to adjust the bias voltage of a power amplifier stage transistor 5 which stimulates an antenna 4 by performing the inventive method. By adjusting the Bias voltage the electrical parameters of the transistor are adapted depending on operation frequency. The basic idea of the inventive method which the shown electronic loop circuit is being designed to perform, is to apply a variable voltage biasing to a radio frequency (RF) power transistor depending on the operating frequency of the transistor and at the same time maintaining the ACLR characteristics of the transistor within values allowed in 3GPP standards.

The inventive bias voltage adjusting method of a power amplifier stage transistor 5 of a base station performed by the electronic loop circuit as shown is comprising the steps of:
- decoupling a fraction of the radio signal to be transmitted,
- downconverting this signal to a baseband of low or medium Intermediate Frequency (IF),
- digitalizing the signal,
- performing an ACLR synthesis of the signal by calculating ACLR values from the digitalised signal depending on frequency values of the signal,
- calculating bias voltage values within ACLR requirements,
- converting said value to an analogue voltage and
- applying said voltage to said transistor as a bias voltage.

The inventive method leads to a minimisation of the operating current, thus to an optimisation of the efficiency of high frequency transistor end stages. According to the invention, simultaneously all spectral masks according to 3GPP standard (TS25.104) are fulfilled minimally in broad band frequency applications. The invention uses the dependency of maximum undesired distortions of a sent signal according to 3GPP standard in connection to an optimisation of the efficiency of the end stage. As rating criteria the ACLR of the amplified signal and optionally the required operating current of the power transistor are used. As adjusting parameter the bias voltage of the transistor is used. Therefore the ACLR values of the end stage are read or calculated, e.g. at +/-5 MHz and +/-10 MHz frequency distance from the high frequency carrier. The required bias voltage is adjusted by a D/A converter and optionally the operating current of the transistor of the end stage is measured.

The fraction of the radio signal to be transmitted is decoupled with a coupler (decoupling means 10). This signal is downconverted to baseband of low or medium Intermediate Frequency (IF) by an analogue downconverter mixer 12. An Analogue/Digital (A/D) Converter 14 digitises the signal. Within a microprocessor (ACLR analysing means 16), preferably a FPGA or DSP, the ACLR synthesis is performed, e.g. using a FFT analysis. The ACLR Optimiser 18 function block performs an ACLR optimising algorithm which adapts the bias voltage to bias voltage values, so that the ACLR requirements are just fulfilled. Using a Digital/Analogue (D/A) Converter 20, the digital signal, i.e. the bias voltage value to be applied using voltage applying means 22 to the transistor 5 of the power amplifier 1, from the ACLR Optimiser 18 finally is converted to an analogue voltage. Additionally, the drain current of the power transistor 5 is measured by drain current measuring means 24 as an additional input for the function block ACLR Optimiser 18, wherein said drain current preferably is converted into a digitalised current value by a second analogue/digital converter 26 before said bias voltage values that just fulfil the ACLR requirements are calculated.

As an example for a transistor (Base Station Transmitter), which can be used in an inventive electronic loop for frequency broadband applications, a GaAs power transistor can be operated under the following operation conditions:
- Operating Frequency (OF)1,5 GHz to 2,5 GHz
- Adjustable Bias Voltage
- Measurement of supply current
- Measurement of ACLR
- Measurement of output power
- Constant input power (Testmodell 3)

The correspondent radio output spectrum measured under transistor data sheet standard conditions is resulting in:

| OF / MHz | ACLR at MHz/dB | | | | U_{bias}/mV | I_{D}/mA | Pout |
|---|---|---|---|---|---|---|---|
| | -5 | +5 | -10 | +10 | | | |
| 1500 | 55 | 54 | 62 | 61 | 700 | 595 | 1 |

Wherein, according to the power transistor datasheet the transistor bias voltage is set fix to - 0,7 V.

When the bias voltage of the transistor is varied, wherein the Bias Voltage is adjusted to even fulfil the ACLR requirements at ± 5 MHz, measurements of the corresponding radio output spectrum at different operating frequencies result in the values of the following table:

| Op. Frequency/MHz | ACLR at MHz/dB | | | | Ubias/mV | ID/mA | ΔPout** |
|---|---|---|---|---|---|---|---|
| | -5 | +5 | -10 | +10 | | | |
| 1500 | 46 | 46 | 62 | 61 | - 765 | 403 | - 0,2 dB |
| Fixed Bias - Not adjusted | | | | | - 700 | 594 | |
| Comparison adjusted / fix (saving) | | | | | | - 191 mA = 32,2 % | |
| 2000 | 45 | 45 | 60 | 61 | - 777 | 399 | - 0,1 dB |
| Fixed Bias - Not adjusted | | | | | - 700 | 591 | |
| Comparison adjusted / fix (saving) | | | | | | - 192mA = 32,5 % | |
| 2500 | 45 | 45 | 60 | 61 | - 789 | 365 | - 0,1 dB |
| Fixed Bias - Not adjusted | | | | | - 700 | 606 | |
| Comparison adjusted / fix (saving) | | | | | | - 241 mA = 39,8 % | |

| | | | | | | | |
|---|---|---|---|---|---|---|---|
| ** = referred to Pout normalised to 1at 1500 MHz and Bias Voltage according data sheet | | | | | | | |

The results of the listed measurements show that a variable Voltage Biasing of high frequency power transistors is practicable to increase the efficiency of power amplifier stages considerably if an increased frequency bandwidth has to be served.

This invention relates to a bias voltage adjusting method of a power amplifier stage transistor of a base station and an electronic loop circuit, being designed to perform the steps of the bias voltage adjusting method. Such methods and circuits are used for efficiency improvement of power amplifier chains preferably within UMTS base stations, in general sending stages of broad band mobile communication systems. The inventive electronic loop circuit is comprising:
- decoupling means 10, being designed to decouple a fraction of a radio signal to be transmitted,
- an analogue/digital converter 14, being designed to convert said fraction of the radio signal to a digitalized signal,
- ACLR analysing means 16, being designed to perform an ACLR analysis of said digitalized signal by calculating an ACLR value from the digitalized signal,
- an ACLR optimiser 18, being designed to calculate a bias voltage value within ACLR requirements,
- a digital/analogue converter 20, being designed to convert said value to an analogue voltage and
- voltage applying means 22, being designed to apply said voltage to said transistor 5 as a bias voltage.

## Claims

1. A bias voltage adjusting method of a power amplifier stage transistor (5) of a base station, comprising the steps of
- decoupling a fraction of a radio signal to be transmitted,
- converting said fraction of the radio signal to a digitalized signal,
- performing an ACLR analysis of said digitalized signal by calculating an ACLR value from the digitalized signal,
- calculating a bias voltage value within ACLR requirements,
- converting said value to an analogue voltage and
- applying said voltage to said transistor as a bias voltage.

2. The bias voltage adjusting method according to claim 1, **characterised in that** the step of downconverting said fraction of said radio signal to a baseband of low or medium Intermediate Frequency (IF) is performed before converting said fraction of the radio signal to said digitalized signal.

3. The bias voltage adjusting method according to claim 1, **characterised in that** said ACLR analysis is comprising a Fast Fourier Transformation (FFT).

4. The bias voltage adjusting method according to claim 1, **characterised in that** a drain current value of a drain current of said transistor (5) is measured and said drain current value is converted into a digitalized current value and said bias voltage value is calculated from said digitalized current value.

5. An electronic loop circuit for adjusting the bias voltage of a power amplifier stage transistor (5) which preferably stimulates an antenna (4),
**characterised in that**
the electronic loop circuit is comprising
- decoupling means (10), being designed to decouple a fraction of a radio signal to be transmitted,
- an analogue/digital converter (14), being designed to convert said fraction of the radio signal to a digitalized signal,
- ACLR analysing means (16), being designed to perform an ACLR analysis of said digitalized signal by calculating an ACLR value from the digitalized signal,
- an ACLR optimiser (18), being designed to calculate a bias voltage value within ACLR requirements,
- a digital/analogue converter (20), being designed to convert said value to an analogue voltage and
- voltage applying means (22), being designed to apply said voltage to said transistor (5) as a bias voltage.

6. The electronic loop circuit according to claim 5, **characterised in that** the electronic loop circuit is comprising an analogue downconverter mixer, being designed to downconvert said fraction of said radio signal to a baseband of low or medium Intermediate Frequency (IF).

7. The electronic loop circuit according to claim 5, **characterised in that** the electronic loop circuit is comprising
- drain current measuring means, being designed to measure a drain current value of a drain current of said transistor, and
- a second analogue/digital converter, being designed to convert said drain current value into a digitalized current value,
wherein
said ACLR optimiser is being designed to calculate said bias voltage value from said digitalized current value.

8. The electronic loop circuit according to claim 5, **characterised in that** said ACLR analysing means and/or said ACLR optimiser is comprising a micro processor, preferably a Field Programmable Gate Array (FPGA) or a Digital Signal Processor (DSP).

9. A transmitter cicuit comprising the circuit of claim 5.

10. A base station comprising the transmitter of claim 9.
